# FASCICULE DE BREVET EUROPEEN

(11) **EP 3 441 859 B1**
(45) Date de publication et mention de la délivrance du brevet: **29.12.2021**
(21) Numéro de dépôt: 18186413.3
(22) Date de dépôt: 30.07.2018
(51) Int. Cl.: G06F 3/041, H01L 27/32, G02F 1/1347, H01L 27/30

(54) **SYSTÈME D'AFFICHAGE ET DE DÉTECTION**
ANZEIGE- UND DETEKTIONSSYSTEM
DISPLAY AND DETECTION SYSTEM

(30) Priorité: 11.08.2017 FR 1757672
(43) Date de publication de la demande: 13.02.2019
(73) Titulaire: ISORG, 87068 Limoges Cedex 3 (FR)
(72) Inventeur: SCHWARTZ, Wilfrid, 38000 GRENOBLE (FR); PUSZKA, Agathe, 38000 GRENOBLE (FR); CHABLE, Quentin, 38000 GRENOBLE (FR); BOUTHINON, Benjamin, 38000 GRENOBLE (FR)
(74) Mandataire: Cabinet Beaumont

(56) Documents cités:
- EP-A1- 3 012 865
- US-A1- 2008 246 708
- US-A1- 2013 127 374
- US-A1- 2017 069 692
- US-B2- 9 647 041

## Description

### Domaine

La présente demande concerne un système d'affichage et de détection et plus particulièrement un système d'affichage associé à un capteur d'image.

### Exposé de l'art antérieur

Pour certaines applications, il est souhaitable de pouvoir détecter une empreinte digitale d'un utilisateur au moyen d'un capteur d'empreintes digitales intégré à un écran d'affichage. A titre d'exemple, un écran muni d'un capteur d'empreintes digitales pourrait équiper des téléphones portables. Il existe des systèmes d'affichage et de détection comprenant un écran d'affichage et un capteur d'images optique qui pourraient permettre la réalisation d'un capteur d'empreintes digitales. Le brevet US 9570002 décrit un exemple d'un tel système d'affichage et de détection comprenant un écran d'affichage et un capteur d'images infrarouges.

US2017/0069692, US9647041 et US2008/0246708 montrent un polariseur recouvrant un capteur d'images et un écran d'affichage.

EP3012865 se rapporte à un écran d'affichage qui est recouvert d'un système électriquement commandable pour contrôler la quantité de lumière qui entre dans ou sort de l'écran d'affichage.

US2013/0127374 décrit un polariseur électriquement commandable en-dessous d'un écran d'affichage et un écran tactile hors de la trajectoire de la lumière émise.

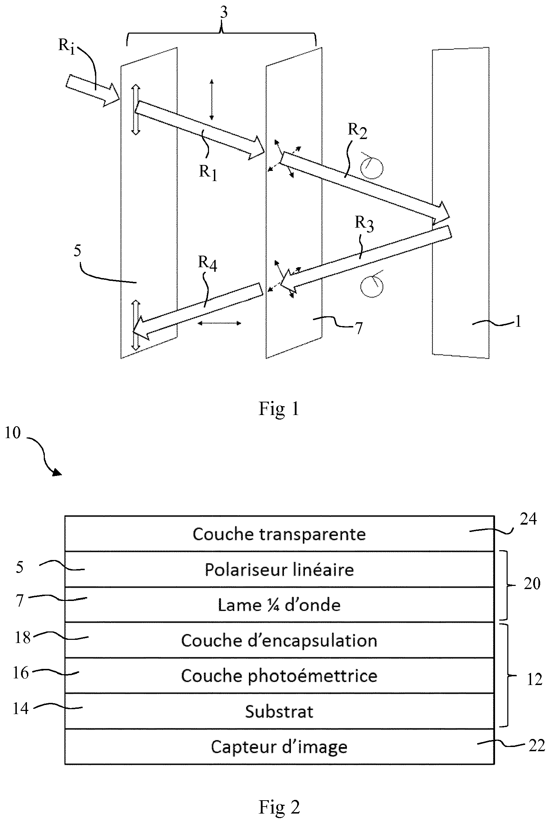

La plupart des écrans d'affichage sont partiellement réfléchissants et il est nécessaire, pour le confort de l'utilisateur, d'atténuer d'éventuels reflets. Ainsi, ces écrans d'affichage sont généralement équipés d'un système antireflet. Un exemple de système antireflet est décrit en relation avec la figure 1.

La figure 1 est une vue éclatée et simplifiée d'un écran d'affichage partiellement réfléchissant 1 recouvert d'un système antireflet 3.

Le système antireflet 3 est positionné devant l'écran d'affichage 1. Le système antireflet 3 comprend un polariseur rectiligne 5 et une lame quart d'onde 7. La lame quart d'onde 7 est positionnée entre le polariseur rectiligne 5 et l'écran d'affichage 1. Les axes de la lame quart d'onde 7 sont orientés à 45 degrés par rapport à l'axe du polariseur rectiligne 5.

Le fonctionnement d'un système antireflet de ce type est le suivant. Un faisceau lumineux Rᵢ non polarisé incident traverse, dans un premier temps, le polariseur rectiligne 5 et devient un faisceau lumineux R₁ à polarisation rectiligne. La lame quart d'onde 7 transforme ensuite le faisceau lumineux R₁ en un faisceau lumineux R₂ à polarisation circulaire droite ou gauche. Ce faisceau R₂ est partiellement réfléchi par l'écran d'affichage 1 en un faisceau lumineux réfléchi R₃. Le faisceau lumineux réfléchi R₃ a une polarisation circulaire inverse à celle du faisceau lumineux R₂, c'est-à-dire gauche ou droite. La lame quart d'onde 7 transforme alors le faisceau lumineux R₃ en un faisceau lumineux R₄ à polarisation rectiligne. La direction de polarisation du faisceau lumineux R₄ est alors orthogonale à celle du faisceau lumineux R₁. Le polariseur 5 empêche alors le faisceau lumineux R₄ de passer.

Il serait souhaitable de pouvoir réaliser un système d'affichage équipé d'un système antireflet comprenant un capteur d'images optique, par exemple un capteur d'empreintes digitales.

### Résumé

Ainsi, un mode de réalisation prévoit un système d'affichage et de détection comprenant :
un capteur d'images ;
un écran d'affichage ; et
un système antireflet recouvrant l'écran d'affichage et le capteur d'image, ce système antireflet comprenant un polariseur rectiligne commandable électriquement.

Selon un mode de réalisation, le système antireflet comprend en outre une lame quart d'onde.

Selon un mode de réalisation, le polariseur rectiligne commandable électriquement est un polariseur à cristaux liquides.

Selon un mode de réalisation, l'écran d'affichage recouvre le capteur d'images.

Selon un mode de réalisation, l'écran d'affichage comprend une couche photoémettrice et une couche d'encapsulation recouvrant la couche photoémettrice.

Selon un mode de réalisation, la couche photoémettrice est une couche de type OLED.

Selon un mode de réalisation, l'écran d'affichage comprend un substrat transparent sur lequel repose la couche photoémettrice.

Selon un mode de réalisation, le système antireflet est recouvert d'un revêtement transparent.

Selon un mode de réalisation, le revêtement transparent est en verre.

Selon un mode de réalisation, le capteur d'images comprend une matrice de capteurs organiques.

Selon un mode de réalisation, le système comprend, en outre, un filtre angulaire, entre le capteur d'images et l'écran d'affichage, adapté à bloquer les rayons incidents dont l'incidence par rapport à une direction orthogonale à une face du filtre angulaire est supérieure à un seuil et à laisser passer au moins certains rayons incidents dont l'incidence par rapport à une direction orthogonale à la face est inférieure au seuil.

Un mode de réalisation prévoit également l'utilisation du système d'affichage et de détection tel que défini précédemment pour la détection d'au moins une empreinte digitale d'un utilisateur.

Selon un mode de réalisation, le capteur d'images joue le rôle d'une surface tactile.

Un mode de réalisation prévoit également un procédé de commande du système d'affichage et de détection tel que défini précédemment, dans lequel le polariseur rectiligne commandable électriquement est désactivé à chaque utilisation du capteur d'images.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, précédemment décrite, illustre un système antireflet ;
la figure 2 est un schéma simplifié d'un système d'affichage et de détection ; et
la figure 3 est un schéma simplifié d'un mode de réalisation d'un système d'affichage et de détection.

### Description détaillée

De mêmes éléments ont été désignés par de mêmes références aux différentes figures. Par souci de clarté, seuls les éléments utiles à la compréhension des modes de réalisation décrits ont été représentés et sont détaillés.

Dans la description qui suit, lorsque l'on fait référence à des qualificatifs de position relative, tels que le terme "dessus", il est fait référence à l'orientation des figures. Sauf précision contraire, l'expression "environ" signifie à 10 % près, de préférence à 5 % près.

Dans la suite de la description, on appelle lumière visible un rayonnement électromagnétique dont la longueur d'onde est comprise entre 400 nm et 700 nm et on appelle rayonnement infrarouge un rayonnement électromagnétique dont la longueur d'onde est comprise entre 700 nm et 10 µm.

Un pixel d'une image correspond à l'élément unitaire de l'image affichée par un écran d'affichage. Lorsque l'écran d'affichage est un écran d'affichage d'images couleur, il comprend en général pour l'affichage de chaque pixel de l'image au moins trois composants d'émission et/ou de régulation de l'intensité lumineuse, également appelés sous-pixels d'affichage, qui émettent chacun un rayonnement lumineux sensiblement dans une seule couleur (par exemple, le rouge, le vert ou le bleu). La superposition des rayonnements émis par ces trois sous-pixels d'affichage fournit à l'observateur la sensation colorée correspondant au pixel de l'image affichée. On appelle dans ce cas pixel d'affichage de l'écran d'affichage l'ensemble formé par les trois sous-pixels d'affichage utilisés pour l'affichage d'un pixel d'une image.

La figure 2 est un schéma simplifié d'un système d'affichage et de détection 10 adapté à afficher une image et à détecter une image, par exemple une empreinte digitale.

Le système d'affichage et de détection 10 comprend un écran d'affichage 12. L'écran d'affichage 12 est par exemple constitué d'un empilement comprenant successivement :
- un substrat transparent 14 par exemple en un polymère ou un verre ;
- une couche photoémettrice 16 reposant sur le substrat 14 et en contact avec celui-ci ; et
- une couche d'encapsulation transparente 18, par exemple en un polymère, reposant sur la couche photoémettrice 16 et en contact avec celle-ci.

Le substrat 14 et la couche d'encapsulation 18 sont transparents à la lumière visible et aux infrarouges.

La couche photoémettrice 16 comprend une matrice de pixels d'affichage. Chaque pixel d'affichage comprend un composant optoélectronique adapté à émettre un rayonnement électromagnétique, appelé aussi composant électroluminescent. Chaque composant électroluminescent correspond par exemple à une diode électroluminescente, notamment à une diode électroluminescente organique (OLED, de l'anglais Organic Light-Emitting Diode). Les pixels d'affichage peuvent, en outre, comprendre des pistes conductrices et des éléments de commutation, notamment des transistors, non représentés, permettant la sélection des pixels d'affichage.

Le système d'affichage et de détection 10 comprend en outre un système antireflet 20 du type de celui décrit en relation avec la figure 1. On y retrouve le polariseur rectiligne 5 et la lame quart d'onde 7. Le système antireflet 20 est disposé sur et en contact avec l'écran d'affichage 12, c'est-à-dire que la lame quart d'onde 7 repose sur et en contact avec la couche d'encapsulation 18 de l'écran d'affichage 12.

Le système d'affichage et de détection 10 comprend en outre un capteur d'images 22. A titre d'exemple, le capteur d'images 22 est situé sous l'écran d'affichage 12, c'est-à-dire que le substrat 14 de l'écran d'affichage 12 repose sur et en contact avec le capteur d'images 22. Le capteur d'images 22 comprend une matrice de capteurs de photons, ou photodétecteurs. Les photodétecteurs sont disposés de façon à ce qu'un rayonnement incident les atteigne après avoir traversé l'écran d'affichage 14. A titre d'exemple, les photodétecteurs sont positionnés au niveau des interstices entre les pixels d'affichage de la couche photoémettrice 16 afin de recevoir un rayonnement lumineux passant entre les pixels d'affichage. Les photodétecteurs peuvent être recouverts d'un revêtement de protection transparent, non représenté. Le capteur d'images 22 comprend, en outre, des pistes conductrices et des éléments de commutation, notamment des transistors, non représentés, permettant la sélection des photodétecteurs. Les photodétecteurs peuvent être réalisés en matériaux organiques. Les photodétecteurs peuvent correspondre à des photodiodes organiques (OPD, de l'anglais Organic Photodiode) ou à des photorésistances organiques.

A titre d'exemple, le capteur d'images 12 peut être utilisé pour détecter l'empreinte digitale d'au moins un doigt d'un utilisateur. De préférence, le capteur d'images 12 peut être utilisé pour détecter simultanément les empreintes digitales de plusieurs doigts de l'utilisateur. Selon un mode de réalisation, le capteur d'images 12 peut jouer le rôle d'une surface tactile, dans lequel la localisation d'un objet ou organe sur le système d'affichage et de détection 10 est déterminée par les photodétecteurs. Le système d'affichage et de détection 10 peut alors être utilisé comme interface utilisateur interactive contrôlable par simple glissement du doigt ou de la main sur la surface tactile. Une telle interface utilisateur interactive peut être utilisée notamment pour commander des téléphones mobiles, des ordinateurs, des postes de télévision, des véhicules automobiles, des billetteries automatiques, des équipements industriels, des équipements médicaux, etc.

Le système d'affichage et de détection 10 comprend en outre un revêtement de protection 24 transparent reposant sur et en contact avec le système antireflet 20. Ce revêtement est transparent à la lumière visible et aux infrarouges. Le revêtement de protection 24 est par exemple une lame de verre ou une couche transparente en un polymère.

Selon un premier mode de fonctionnement, un objet ou organe, par exemple un doigt, peut être éclairé par une source externe au système d'affichage et de détection qui émet un rayonnement qui traverse ou est réfléchi par l'objet ou organe. L'objet ou organe émet alors un rayonnement lumineux non polarisé en direction des photodétecteurs du capteur d'images 22. Ce rayonnement non polarisé traverse le polariseur 5 et 50 % de son intensité est perdue.

Selon un deuxième mode de fonctionnement, l'objet ou l'organe n'est pas éclairé par une source externe, il est alors éclairé par un rayonnement lumineux non polarisé émis par la couche photoémettrice 16 de l'écran d'affichage 12. Le rayonnement lumineux se polarise et perd une partie de son intensité en traversant le polarisateur 5. Ce rayonnement lumineux se reflète sur l'objet ou l'organe et est réfléchi. Le rayonnement réfléchi traverse le polariseur 5 et perd à nouveau une partie de son intensité.

Ainsi, un inconvénient de ce système d'affichage et de détection 10 est que le polariseur 5 du système antireflet 20 diminue la luminosité de l'image de l'objet ou organe sur le capteur d'images 22.

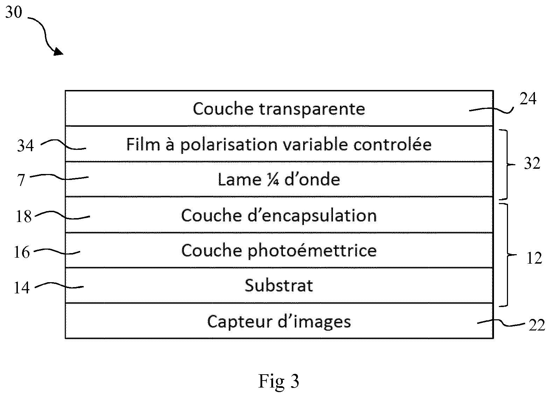

La figure 3 est un schéma simplifié d'un mode de réalisation d'un système d'affichage et de détection 30 adapté à détecter une image, par exemple une empreinte digitale. Le système d'affichage et de détection 30 comprend certains des éléments du système d'affichage et de détection 10 décrit en relation avec la figure 2, à savoir l'écran d'affichage 12, comprenant le substrat 14, la couche photoémettrice 16 et la couche d'encapsulation 18, le capteur d'image 22 et une couche transparente 24.

Le système d'affichage et de détection 30 comprend en outre un système antireflet 32 comprenant la lame quart d'onde 7 décrite en relation avec la figure 2 et un polariseur rectiligne commandable électriquement 34. Un polariseur rectiligne commandable électriquement est un polariseur qui, sous l'influence d'un champ électrique, peut soit devenir polarisant soit perdre son caractère polarisant.

Un exemple de polariseur rectiligne commandable électriquement est un polariseur à cristaux liquides. Les cristaux liquides sont sensibles à l'influence d'un champ électrique. Dans le cas de cristaux liquides nématiques, les cristaux liquides ne sont pas polarisants au repos. Lorsqu'on leur applique un champ électrique les cristaux liquides s'organisent et deviennent polarisants. Dans le cas de cristaux liquides cholestériques, les cristaux liquides sont polarisants au repos. Lorsqu'on leur applique un champ électrique, les cristaux liquides perdent leur caractère polarisant.

On peut alors prévoir un circuit de commande du polariseur rectiligne 34. Ce circuit de commande peut comprendre un interrupteur qui, suivant le type des cristaux liquides constituant le polariseur, s'ouvre ou se ferme pour appliquer ou non un champ électrique au polariseur rectiligne 34. Cet interrupteur peut être commandé manuellement ou par un signal émis à chaque fois que l'on souhaite utiliser le capteur d'image, par exemple pour acquérir une empreinte digitale.

Un avantage de ce mode de réalisation est que l'on peut activer ou désactiver le polariseur rectiligne 34 à volonté. Lorsque l'on souhaite utiliser le capteur d'images, on désactive le polariseur rectiligne 34 de sorte qu'il ne polarise plus la lumière qui le traverse. Dans le cas d'un polariseur à cristaux liquides nématiques, la désactivation du polariseur rectiligne 34 est obtenue en interrompant l'application d'un champ électrique sur les cristaux liquides pour qu'ils perdent leur caractère polarisant. Dans le cas d'un polariseur à cristaux liquides cholestériques, la désactivation du polariseur rectiligne 34 est obtenue en soumettant les cristaux liquides à un champ électrique pour qu'ils perdent leur caractère polarisant. La luminosité de l'image produite par le capteur n'est alors pas diminuée par le polariseur rectiligne 34.

Lorsque l'on souhaite utiliser l'écran d'affichage 12 seul sans le capteur d'images 22, on active le polariseur rectiligne 34 de sorte qu'il polarise la lumière qui le traverse. Le système antireflet 32 fonctionne alors comme celui décrit en relation avec la figure 1 et élimine les éventuels reflets du système d'affichage et de détection 30.

Des modes de réalisation particuliers ont été décrits. Diverses variantes et modifications apparaîtront à l'homme de l'art. En particulier, l'intensité lumineuse de l'écran peut s'adapter à chaque activation ou désactivation du polariseur rectiligne 34 afin de respecter les normes sur l'éclairement maximal d'un écran.

Le système d'affichage et de détection peut comprendre une surface tactile en plus du capteur d'images 22 qui peut être alors dédié à l'acquisition d'empreintes digitales.

Dans les modes de réalisation décrits précédemment, l'écran d'affichage 12 recouvre le capteur d'images 22. A titre de variante, le capteur d'images peut être formé directement au niveau de la couche émettrice dans l'écran d'affichage, par exemple en disposant les photodétecteurs dans les interstices entre les pixels d'affichage dans la couche photoémettrice 16.

De plus, le système d'affichage et de détection peut en outre comprendre un filtre angulaire disposé entre l'écran d'affichage 12 et le capteur d'images 22. Le filtre angulaire est adapté à filtrer le rayonnement incident en fonction de l'incidence du rayonnement par rapport à la face supérieure du filtre angulaire, notamment pour que le capteur d'images 22 reçoive seulement les rayons dont l'incidence par rapport à un axe perpendiculaire à la face supérieure du filtre angulaire est inférieure à un angle d'incidence maximale inférieur à 45°, de préférence inférieur à 30°, plus préférentiellement inférieur à 20°, encore plus préférentiellement inférieur à 10°. Le filtre angulaire 16 est adapté à bloquer les rayons du rayonnement indicent dont l'incidence par rapport à un axe perpendiculaire à la face supérieure du filtre angulaire est supérieure à l'angle d'incidence maximale. Le filtre angulaire peut comprendre une matrice de trous délimités par des murs opaques audit rayonnement.

Divers modes de réalisation avec diverses variantes ont été décrits ci-dessus. On notera que l'homme de l'art pourra combiner divers éléments de ces divers modes de réalisation et variantes sans faire preuve d'activité inventive.

## Revendications

1. Système d'affichage et de détection (30) comprenant :
un capteur d'images (22) ;
un écran d'affichage (12) ; et
un système antireflet (32) recouvrant l'écran d'affichage (12) et le capteur d'image (22), **caractérisé en ce que** ce système antireflet comprend un polariseur rectiligne commandable électriquement (34).

2. Système d'affichage et de détection (30) selon la revendication 1, dans lequel le système antireflet (32) comprend en outre une lame quart d'onde (7).

3. Système d'affichage et de détection selon la revendication 1 ou 2, dans lequel le polariseur rectiligne commandable électriquement (34) est un polariseur à cristaux liquides.

4. Système d'affichage et de détection selon l'une quelconque des revendications 1 à 3, dans lequel l'écran d'affichage (12) recouvre le capteur d'images (22).

5. Système d'affichage et de détection selon l'une quelconque des revendications 1 à 4, dans lequel l'écran d'affichage (12) comprend une couche photoémettrice (16) et une couche d'encapsulation (18) recouvrant la couche photoémettrice (16).

6. Système d'affichage et de détection selon la revendication 5, dans lequel la couche photoémettrice (16) est une couche de type OLED.

7. Système d'affichage et de détection selon la revendication 5 ou 6, dans lequel l'écran d'affichage (12) comprend un substrat transparent (14) sur lequel repose la couche photoémettrice (16).

8. Système d'affichage et de détection selon l'une quelconque des revendications 1 à 7, dans lequel le système antireflet (32) est recouvert d'un revêtement transparent (24).

9. Système d'affichage et de détection selon la revendication 8, dans lequel le revêtement transparent (24) est en verre.

10. Système d'affichage et de détection selon l'une quelconque des revendications 1 à 9, dans lequel le capteur d'images (22) comprend une matrice de capteurs organiques.

11. Système d'affichage et de détection selon l'une quelconque des revendications 1 à 10, comprenant, en outre, un filtre angulaire, entre le capteur d'images (22) et l'écran d'affichage (12), adapté à bloquer les rayons incidents dont l'incidence par rapport à une direction orthogonale à une face du filtre angulaire est supérieure à un seuil et à laisser passer au moins certains rayons incidents dont l'incidence par rapport à une direction orthogonale à la face est inférieure au seuil.

12. Utilisation du système d'affichage et de détection selon l'une quelconque des revendications 1 à 11 pour la détection d'au moins une empreinte digitale d'un utilisateur.

13. Utilisation selon la revendication 12, dans laquelle le capteur d'images (22) joue le rôle d'une surface tactile.

14. Procédé de commande du système d'affichage et de détection (30) selon l'une quelconque des revendications 1 à 11, dans lequel le polariseur rectiligne commandable électriquement (34) est désactivé à chaque utilisation du capteur d'images (22).

## Patentansprüche

1. Ein Anzeige- und Erfassungssystem (30), das Folgendes aufweist:
einen Bildsensor (22);
einen Anzeigeschirm (12); und
ein Antireflexionssystem (32), das den Anzeigeschirm (12) und den Bildsensor (22) abdeckt, **dadurch gekennzeichnet, dass** das Antireflexionssystem einen elektrisch steuerbaren linearen Polarisator (34) aufweist.

2. Anzeige- und Erfassungssystem (30) nach Anspruch 1, wobei das Antireflexionssystem (32) ferner eine Viertelwellenplatte (7) aufweist.

3. Anzeige- und Erfassungssystem nach Anspruch 1 oder 2, wobei der elektrisch steuerbare lineare Polarisator (34) ein Flüssigkristallpolarisator ist.

4. Anzeige- und Erfassungssystem nach einem der Ansprüche 1 bis 3, wobei der Bildschirm (12) den Bildsensor (22) abdeckt.

5. Anzeige- und Erfassungssystem nach einem der Ansprüche 1 bis 4, wobei der Anzeigeschirm (12) eine lichtemittierende Schicht (16) und eine die lichtemittierende Schicht (16) bedeckende Verkapselungsschicht (18) aufweist.

6. Anzeige- und Erfassungssystem nach Anspruch 5, wobei die lichtemittierende Schicht (16) eine Schicht vom OLED-Typ ist.

7. Anzeige- und Erfassungssystem nach Anspruch 5 oder 6, wobei der Anzeigeschirm (12) ein transparentes Substrat (14) aufweist, auf dem die lichtemittierende Schicht (16) aufliegt.

8. Anzeige- und Erfassungssystem nach einem der Ansprüche 1 bis 7, wobei das Antireflexionssystem (32) mit einer transparenten Beschichtung (24) bedeckt ist.

9. Anzeige- und Erfassungssystem nach Anspruch 8, wobei die transparente Beschichtung (24) aus Glas hergestellt ist.

10. Anzeige- und Erfassungssystem nach einem der Ansprüche 1 bis 9, wobei der Bildsensor (22) ein Array aus organischen Sensoren aufweist.

11. Anzeige- und Erfassungssystem nach einem der Ansprüche 1 bis 10, ferner mit einem Winkelfilter zwischen dem Bildsensor (22) und dem Anzeigeschirm (12), der in der Lage ist, einfallende Strahlen zu blockieren, deren Einfall in Bezug auf eine Richtung orthogonal zu einer Oberfläche des Winkelfilters größer als ein Schwellenwert ist, und zumindest bestimmte einfallende Strahlen durchzulassen, deren Einfall in Bezug auf eine Richtung orthogonal zu der Oberfläche kleiner als der Schwellenwert ist.

12. Verwendung des Anzeige- und Erfassungssystems nach einem der Ansprüche 1 bis 11 zur Erfassung mindestens eines Fingerabdrucks eines Benutzers.

13. Verwendung nach Anspruch 12, wobei der Bildsensor (22) die Rolle einer Berührungsfläche spielt.

14. Verfahren zur Steuerung des Anzeige- und Erfassungssystems (30) nach einem der Ansprüche 1 bis 11, wobei der elektrisch steuerbare lineare Polarisator (34) bei jeder Verwendung des Bildsensors (22) deaktiviert wird.

## Claims

1. A display and detection system (30) comprising:
an image sensor (22);
a display screen (12); and
an antireflection system (32) covering the display screen (12) and the image sensor (22), **characterized in that** the antireflection system comprises an electrically-controllable rectilinear polarizer (34).

2. The display and detection system (30) of claim 1, wherein the antireflection system (32) further comprises a quarter-wave plate (7).

3. The display and detection system of claim 1 or 2, wherein the electrically-controllable rectilinear polarizer (34) is a liquid crystal polarizer.

4. The display and detection system of any of claims 1 to 3, wherein the display screen (12) covers the image sensor (22) .

5. The display and detection system of any of claims 1 to 4, wherein the display screen (12) comprises a light-emitting layer (16) and an encapsulation layer (18) covering the light emitting layer (16).

6. The display and detection system of claim 5, wherein the light-emitting layer (16) is an OLED-type layer.

7. The display and detection system of claim 5 or 6, wherein the display screen (12) comprises a transparent substrate (14) having the light-emitting layer (16) resting thereon.

8. The display and detection system of any of claims 1 to 7, wherein the antireflection system (32) is covered with a transparent coating (24).

9. The display and detection system of claim 8, wherein the transparent coating (24) is made of glass.

10. The display and detection system of any of claims 1 to 9, wherein the image sensor (22) comprises an array of organic sensors.

11. The display and detection system of any of claims 1 to 10, further comprising an angular filter, between the image sensor (22) and the display screen (12), capable of blocking incident rays having an incidence relative to a direction orthogonal to a surface of the angular filter greater than a threshold and of letting through at least certain incident rays having an incidence relative to a direction orthogonal to the surface smaller than the threshold.

12. A use of the display and detection system of any of claims 1 to 11 for the detection of at least one fingerprint of a user.

13. The use of claim 12, wherein the image sensor (22) plays the role of a touch surface.

14. A method of controlling the display and detection system (30) of any of claims 1 to 11, wherein the electrically controllable rectilinear polarizer (34) is deactivated on each use of the image sensor (22).
